(19) Europäisches Patentamt
European Patent Office
Office européen des brevets

(11) **EP 1 780 809 A1**

(12) **EUROPEAN PATENT APPLICATION**
published in accordance with Art. 158(3) EPC

(43) Date of publication:
**02.05.2007 Bulletin 2007/18**

(51) Int Cl.:
*H01L 35/32* (2006.01)   *H02N 11/00* (2006.01)

(21) Application number: **05743917.6**

(22) Date of filing: **25.05.2005**

(86) International application number:
**PCT/JP2005/009577**

(87) International publication number:
**WO 2005/124882 (29.12.2005 Gazette 2005/52)**

(84) Designated Contracting States:
**AT BE BG CH CY CZ DE DK EE ES FI FR GB GR HU IE IS IT LI LT LU MC NL PL PT RO SE SI SK TR**

(30) Priority: **17.06.2004 JP 2004179199**

(71) Applicant: **Aruze Corporation**
**Tokyo 135-0063 (JP)**

(72) Inventor: **TAKAHASHI, Koh**
**Tokyo 1350063 (JP)**

(74) Representative: **HOFFMANN EITLE**
**Patent- und Rechtsanwälte**
**Arabellastrasse 4**
**81925 München (DE)**

(54) **THERMOELECTRIC CONVERSION MODULE**

(57)   A thermoelectric conversion module which includes a good thermally conductive substrate that is inexpensive, and which secures the electrical insulating property between the good thermally conductive substrate and the electrode. The thermoelectric conversion element unit is constituted of a P-type semiconductor 1 and an N-type semiconductor 2 which are connected to form a π-shape. Electrodes 3 to 5 are connected to both end faces of the thermoelectric conversion element units. The good thermally conductive substrate 8 and 9 are brought in contact with the electrodes 3 to 5. The good thermally conductive substrates 8 and 9 consist of an aluminum or an aluminum alloy, and an anode oxide film 10 is provided between the good thermally conductive substrates 8, 9, and the electrodes 3 to 5. The thermoelectric conversion module 20 has the good thermally conductive substrates 8 and 9 consisting of inexpensive aluminum or aluminum alloy, and the electrical insulating property between the good thermally conductive substrate and the electrode can be secured by the anode oxide film 10.

Fig. 1

**Description**

TECHNICAL FIELD

The present invention relates to a thermoelectric conversion module. In particular, the invention relates to a thermoelectric conversion module in which the Seebeck effect or Peltier effect is utilized.

BACKGROUND ART

Physical phenomena such as the Seebeck effect and Peltier effect in which heat current and electrical current influence one another are generally referred to as "thermoelectric effects". Thermoelectric effects are exhibited in a circuit in which metal(s) and/or semiconductor(s) having different thermoelectric properties are joined. The generation of an electric current in such a circuit when there is a difference in temperature at the junction is referred to as the Seebeck effect. Thermoelectric conversion modules which exhibit the Seebeck effect have been utilized as, for example, a power generating apparatus.

Meanwhile, when an electrical current flows through a circuit, the generation of heat on one side and absorption of heat on the other side of the junction occurs. This is referred to as the Peltier effect. Thermoelectric conversion modules using the Peltier effect are also referred to as Peltier elements. Such Peltier elements have been utilized for thermoelectric cooling, for example, for CPU; (Central Processing Unit) and the like.

In typical thermoelectric conversion modules, different thermoelectric conversion materials, i.e., the P-type semiconductors and the N-type semiconductors are arranged in parallel, and a closed circuit is constructed by serially connecting the P-type semiconductor and the N-type semiconductor to form a π-shape. When an electrical current flows through this closed circuit in one direction, heat is released or absorbed depending on the direction of the electrical current at the junction of the P-type semiconductor and the N-type semiconductor.

The thermoelectric conversion module having the aforementioned construction absorbs heat at one end face of the P-type semiconductor and N-type semiconductor, while it generates heat at another end face of the P-type semiconductor and N-type semiconductor. In contrast, according to the thermoelectric conversion module having the aforementioned construction, an electrical current will flow in the closed circuit, which can be drawn as an electric power, by providing a temperature difference between both end faces of the P-type semiconductor and the N-type semiconductor when using one end face of the P-type semiconductor and N-type semiconductor to serve as the low temperature face; and another end face of the P-type semiconductor and N-type semiconductor to serve as the high temperature face.

Accordingly, thermoelectric conversion modules have almost the same fundamental construction, and reversible action, i.e., either power generation utilizing the Seebeck effect, or temperature control utilizing the Peltier effect, can occur. Therefore, the thermoelectric conversion module can be also utilized as both a thermoelectric generation element module and a Peltier element (thermoelectric cooling element module).

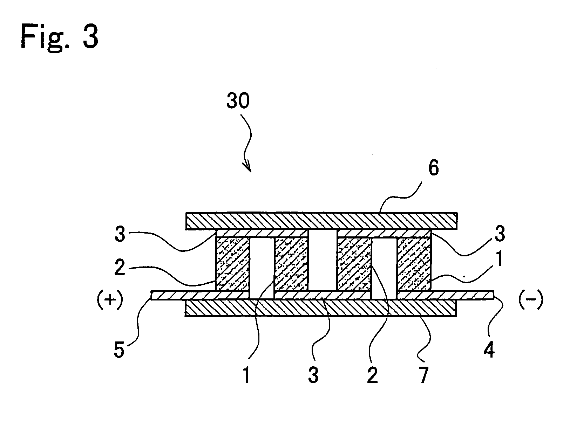

Next, a thermoelectric conversion module as a conventional typical Peltier element will be explained with reference to Fig. 3. Fig. 3 shows a front view illustrating the construction of a conventional thermoelectric conversion module. In Fig. 3, reference numeral 1 denotes the P-type semiconductor, and reference numeral 2 denotes the N-type semiconductor. As shown in Fig. 3, the P-type semiconductors 1 and the N-type semiconductors 2 are alternately provided in parallel.

The P-type semiconductor 1 and the N-type semiconductor 2 are connected via an electrode 3, to form a π-shape. At the bottom end face of the P-type semiconductor 1 disposed on one end side is connected an electrode 4 which is externally connected, and at the bottom end face of the N-type semiconductor 2 disposed on another end side is connected an electrode 5 which is externally connected. The P-type semiconductors 1 and the N-type semiconductors 2 are serially connected between the electrode 4 and the electrode 5 to form a π-shapes.

In Fig. 3, a good thermally conductive substrate 6 comes in contact with the electrodes 3 connected to the upper end face of the P-type semiconductors 1 and the N-type semiconductors 2. A good thermally conductive substrate 7 comes in contact with the electrodes 3 to 5 connected to the bottom end face of the P-type semiconductor 1 and the N-type semiconductor 2. A ceramic having an electrical insulating property such as aluminum nitride (AlN) or aluminum oxide ($Al_2O_3$) is used for the good thermally conductive substrates 6 and 7.

In Fig. 3, a direct-current power source is connected between the electrode 4 and the electrode 5. Thus, when an electrical current flows through the thermoelectric conversion module 30 where the electrode 5 serves as the positive (+) side, and the electrode 4 serves as the negative (-) side, the good thermally conductive substrate 6 is cooled, while the good thermally conductive substrate 7 is heated.

In contrast, when a closed circuit is constructed by connecting a load between the electrode 4 and the electrode 5 in Fig. 3, and a temperature difference is imparted between the good thermally conductive substrate 6 and the good thermally conductive substrate 7 where in the good thermally conductive substrate 6 serves as the low temperature side, and the good thermally conductive substrate 7 to serve as the high temperature side, an electrical current flows in the closed circuit, which can be drawn as an electric power.

Novel and useful thermoelectric generation element modules having a construction which has similar structure to one shown in Fig. 3, and having an electrical insulating film have been developed (for example, see Patent Document 1).

The thermoelectric generation element module according to Patent Document 1 is a thermoelectric conversion element unit module in which a P-type thermoelectric conversion material and an N-type thermoelectric conversion material are alternately connected via electrodes. The module is characterized in that the surface of the electrode has an electrical insulating film consisting of a silica film formed by applying a polysilazane solution including -(SiH$_2$NH)- as a structural unit.

The insulating film according to the invention of Patent Document 1 is reportedly excellent in heat resistance and thermal conductivity and effective over a broad temperature range, from ordinary temperatures to 1300°C, particularly in the range of higher temperatures of 600 to 1300°C. In addition, according to the invention of Patent Document 1, thermal resistance can be greatly minimized because the silica thin film can be formed to be ultrathin such as for example, to have a film thickness of 1 $\mu$m. Therefore, excellent effects are reported such as avoidance of substantial deterioration of the power generation performance of the thermoelectric conversion element module.

Patent Document 1: Japanese Unexamined Patent Application Publication No. 2001-326394

DISCLOSURE OF THE INVENTION

Problems to be solved by the Invention

In the conventional typical thermoelectric conversion module shown in Fig. 3, a ceramic such as aluminum nitride or aluminum oxide is used as the good thermally conductive substrate, taking into consideration the electrical insulating property and thermal conductivity. According to the invention of Patent Document 1, an alumina porcelain (Al$_2$O$_3$) is used as the good thermally conductive substrate in the Examples thereof.

However, aluminum nitride (AIN) which may be used as the good thermally conductive substrate is disadvantageous in being generally expensive, although it is favorable in terms of electrical insulating properties and thermal conductivity. In contrast, aluminum oxide (Al$_2$O$_3$) which may be used as the good thermally conductive substrate is inexpensive and favorable in electrical insulating property, but it is disadvantageous in inferior thermal conductivity.

The present invention was made in order to solve the foregoing problems. An object of the present invention is to provide a thermoelectric conversion module which includes a good thermally conductive substrate that is inexpensive, and which secures the electrical insulating property between the good thermally conductive substrate and the electrode.

Means for Solving the Problems

The present inventors accomplished the invention of a novel thermoelectric conversion module as described below for attaining the aforementioned object with a constitution wherein the good thermally conductive substrate comprising a general metal having low thermal resistance, with an electrical insulating film disposed between the good thermally conductive substrate and the electrode.

According to a first aspect of a thermoelectric conversion module equipping a thermoelectric conversion element unit constructed with a P-type semiconductor and an N-type semiconductor connected to form a $\pi$-shape, an electrode connected to each end face of the thermoelectric conversion element unit, and a good thermally conductive substrate which is in contact with the electrode, wherein the good thermally conductive substrate comprises aluminum or an aluminum alloy, and an anode oxide film is provided between the good thermally conductive substrate and the electrode.

The thermoelectric conversion module according to the above aspect of the present invention has a thermoelectric conversion element unit constituted of a P-type semiconductor and an N-type semiconductor connected to form a $\pi$-shape. For the thermoelectric conversion element unit constituted of a P-type semiconductor and N-type semiconductor, a generally used material such as e.g., a bismuth-tellurium compound, an antimony-tellurium compound, a bismuth-tellurium-antimony compound, a bismuth-tellurium-selenium compound, as well as a lead-germanium compound, a silicon-germanium compound or the like may be used. The P-type semiconductor and N-type semiconductor may be formed into, for example, a columnar shape, and both of the generally parallel ends of the P-type semiconductor and the N-type semiconductor have an electrically connective end face.

Furthermore, the P-type semiconductor and the N-type semiconductor have generally the same height, and the P-type semiconductor and the N-type semiconductor are connected to form a $\pi$-shape. The connection of the P-type semiconductor and the N-type semiconductor to form the $\pi$-shape mean that the P-type semiconductor and the N-type semiconductor are serially connected.

The thermoelectric conversion module according to the present invention has electrodes connected to both end faces of the thermoelectric conversion element unit. The electrode may be, for example, a tabular conductive metal plate, and the electric resistance of the electrode is preferably low. The electrode may be joined to both end faces of the thermoelectric conversion element unit to allow them to be electrically connected. For example, the joining may be effected by soldering, or by welding. Furthermore, the electrode may be adhered to both end faces of the thermoelectric conversion element unit by a conductive adhesive to allow them to be electrically connected.

Moreover, the electrode may be formed by, for example, attaching a copper foil plate to an electrical insulating film and subjecting this copper foil plate to pattern etching, and the pattern-etched electrode may be brought into contact with both end faces of the thermoelectric conversion element unit, thereby connecting the electrode to both end faces of the thermoelectric conversion element unit. Also, a pattern-etched electrode may be subjected to conductive plating.

The thermoelectric conversion module according to the present invention has a good thermally conductive substrate which comes in contact with the electrode. For example, a pair of opposing good thermally conductive substrates may sandwich and come into contact with the electrode by means of heat insulating columnar supports. Also, a good thermally conductive material such as silicone may be provided between the electrode and the good thermally conductive substrate, and the good thermally conductive substrate may be brought into contact with the electrode.

The thermoelectric conversion module according to the present invention is characterized in that the good thermally conductive substrate consists of aluminum or an aluminum alloy.

The aluminum which may be used as the good thermally conductive substrate according to the invention may be a pure aluminum, and a pure industrial aluminum having a purity of 99.7 to 99.0% is preferred in light of availability and cost.

The aluminum alloy which may be applied as the good thermally conductive substrate according to the invention may be, for example, an Al-Mg compound or an Al-Mn compound which is reinforced by processing and hardening for the purpose of achieving corrosion resistance, and may be an Al-Mg-Si compound having thermal processability and favorable corrosion resistance. For making the good thermally conductive substrate according to the invention with the aluminum alloy for casting such as die casting, an Al-Cu compound, an Al-Cu-Si compound (lautal or the like), an Al-Si compound (silumin or the like), an Al-Mg compound (hydronalium or the like), an Al-Cu-Mg-Ni compound (Y alloy or the like) may be used (the above grouping of the aluminum alloys is excerpted from the "Iwanami Physical and Chemical Dictionary, 5th ed., Iwanami. Press").

Moreover, the thermoelectric conversion module according to the present invention is characterized in that an anode oxide film is provided between the good thermally conductive substrate and the electrode.

As described above, the thermoelectric conversion module according to the present invention includes: a thermoelectric conversion element unit having a P-type semiconductor and an N-type semiconductor connected to form a $\pi$-shape between two opposing faces; electrodes each arranged on the two opposing faces of the $\pi$-shaped connection of the thermoelectric conversion element units; and a good thermally conductive substrate which comes in contact with the electrode arranged on at least one face of the electrode, and the thermoelectric conversion module may be characterized in that the good thermally conductive substrate consists of an aluminum or an aluminum alloy, and an anode oxide film is provided between the good thermally conductive substrate and the electrode to come in contact therewith.

Because the aluminum or aluminum alloy has inferior thermal resistance but has more favorable conductivity compared with aluminum nitride (AlN) or aluminum oxide ($Al_2O_3$), the electrodes will short when the good thermally conductive substrate consisting of the aluminum or aluminum alloy comes in contact with the electrode. Therefore, the anode oxide film having the electrical insulating property is provided between the good thermally conductive substrate having favorable conductivity and the electrode to secure the electrical insulating property between the good thermally conductive substrate and the electrode.

Hence, the thermoelectric conversion module according to the present invention includes the good thermally conductive substrate consisting of inexpensive aluminum or aluminum alloy, and the anode oxide film having the electrical insulating property is provided between the good thermally conductive substrate and the electrode, thereby securing the electrical insulating property between the good thermally conductive substrate and the electrode.

According to a second aspect of the thermoelectric conversion module as described in the first aspect of the present invention, wherein the anode oxide film is formed on the good thermally conductive substrate consisting of the aluminum or the aluminum alloy.

Anode oxidation is an oxidative reaction that occurs on the anode upon the electrolysis, and the anode oxide film of $Al_2O_3$ formed on the surface of the aluminum or the aluminum alloy by electrolyzing the aluminum or the aluminum alloy in an electrolytic solution such as sulfuric acid has an electrical insulating property.

By thus forming the anode oxide film having the electrical insulating property on the good thermally conductive substrate consisting of the aluminum or the aluminum alloy, the electrical insulating property between the good thermally conductive substrate and the electrode can be secured.

Although the anode oxide film immediately after the electrolysis is porous and amorphous $Al_2O_3$, sealing can be executed when a treatment with boiling water or a treatment with steam is carried out. In this state, favorable corrosion resistance and electrical insulating property will be achieved. Thus, by subjecting the anode oxide film formed on the good thermally conductive substrate to for example, a sealing treatment, the surface roughness of the face of the good thermally conductive substrate which comes in contact with the electrode is decreased, whereby the contact thermal resistance can be diminished.

According to the present invention, the anode oxide film may not be necessarily formed on the entire good thermally conductive substrate which comes in contact with the electrode. One of the pair of opposing good thermally conductive substrates may consist of the aluminum or the aluminum alloy on which the anode oxide film may be formed, while the opposing good thermally conductive substrate may consist of, for example, aluminum nitride (AlN). For example, in a Peltier element, the good thermally conductive substrate on the cooling side may consist of aluminum nitride, and the good thermally conductive substrate on the heat releasing side may consist of the aluminum or the aluminum alloy on which the anode oxide film may be formed.

According to a third aspect of the thermoelectric conversion module according to the second aspect of the present invention, wherein the anode oxide film is formed to have a film thickness of 0.1 to 0.5 $\mu$m.

As described above, the anode oxide film formed on the good thermally conductive substrate consisting of the aluminum or the aluminum alloy has an electrical insulating property. Moreover, as the anode oxide film has a greater film thickness, the electrical insulating property is believed to be enhanced. On the other hand, as the anode oxide film has a greater film thickness, the thermal resistance is also believed to be increased.

The anode oxide film formed on the aluminum or the aluminum alloy can be formed, in the case of a porous film, to give an average film thickness generally in the range of 1 to 100 $\mu$m. In light of the electrical insulating property, it is preferred to form it with an average film thickness of 20 $\mu$m or greater. In light of minimizing the thermal resistance and securing the electrical insulating property, it is formed with an average film thickness preferably in the range of 20 to 80 $\mu$m, more preferably in the range of 25 to 60 $\mu$m, and still more preferably in the range of 30 to 40 $\mu$m.

It is more preferred that a barrier-type film be formed as the anode oxide film formed on the aluminum or the aluminum alloy. The barrier-type film may be formed in a neutral liquid including, for example, ammonium borate or the like, and is advantageous in being compact and excellent in the electrical insulating property. Furthermore, since crystals grow linearly with respect to the voltage at the barrier-type film, the film thickness can be controlled.

In the case of such a barrier-type film, the average film thickness can be reportedly formed generally in the range of 0.01 to 0.8 $\mu$m. In light of the electrical insulating property, it is formed to have a film thickness of preferably 0.1 $\mu$m or greater, while in light of minimizing the thermal resistance while securing the electrical insulating property, it is preferred to be formed to have a film thickness in the range of 0.1 to 0.5 $\mu$m.

According to a forth aspect of the thermoelectric conversion module according to the first to the third aspects of the present invention, wherein multiple thermoelectric conversion element units provided in parallel are sandwiched between the good thermally conductive substrates.

The thermoelectric conversion module according to the present invention can further include another thermoelectric conversion element unit including the P-type semiconductor and the N-type semiconductor connected to form a $\pi$-shape, which is provided in parallel to the thermoelectric conversion element unit between the opposing two faces, and serially connected thereto. In other words, the thermoelectric conversion module provided with multiple (an arbitrary umber of) thermoelectric conversion element units together in parallel can be also included in the present invention.

The phrase "the multiple thermoelectric conversion element units provided together in parallel" may be construed as referring to, for example, multiple P-type semiconductors and multiple N-type semiconductors formed into a columnar shape being arranged alternately adjacent each other, and aligned standing in rows and columns. The multiple P-type semiconductors and the multiple N-type semiconductors have generally the same height, and the multiple P-type semiconductors and the multiple N-type semiconductors are serially connected to form the $\pi$-shapes.

For example, the multiple P-type semiconductors and the multiple N-type semiconductors are alternately arranged along a column, and the electrodes are connected to both end faces of the multiple thermoelectric conversion element units in the direction of the column. Additionally, each one end face of a pair of the P-type semiconductor and the N-type semiconductor arranged at both edges in this column direction is connected with the electrode.

With regard to these multiple electrodes, the multiple thermoelectric conversion element units are arranged in the aligned orientation such that the multiple electrodes arranged on one face correspond to the heat absorbing side, and the multiple electrodes arranged on another face correspond to the heat releasing side. The arranged multiple electrodes are sandwiched between the good thermally conductive substrates to be brought into contact therewith.

For example, a heat insulating columnar support may be interposed between a pair of the opposing good thermally conductive substrates to sandwich multiple thermoelectric conversion element units. Alternatively, a nonconductive liquid packing may be interposed between a pair of the opposing good thermally conductive substrates, and the liquid packing may adhere to the pair of the opposing good thermally conductive substrates, thereby sandwiching the multiple thermoelectric conversion element units.

Because the thermoelectric conversion module of the present invention includes multiple thermoelectric conversion element units arranged in this manner, desired electric power can be obtained from a thermoelectric generation element module, or a desired cooling ability can be obtained from a Peltier element, by appropriately setting the number of the thermoelectric conversion element units.

The thermoelectric conversion module of the present invention includes a good thermally conductive substrate comprising inexpensive aluminum or aluminum alloy, and the anode oxide film having the electrical insulating property is provided between the good thermally conductive substrate and the electrode, whereby the electrical insulating property between the good thermally conductive substrate and the electrode can be secured.

BRIEF DESCRIPTION OF THE DRAWINGS

Fig. 1 shows a front view illustrating the construction of the thermoelectric conversion module according to one embodiment of the present invention.
Fig. 2 shows an exploded, perspective view illustrating the thermoelectric conversion module according to another embodiment of the present invention.
Fig. 3 shows a front view illustrating the construction of the conventional thermoelectric conversion module.

Description of the Numerals

| 1 | P-type semiconductor |
| 2 | N-type semiconductor |
| 3-5 | electrode |
| 8,9,81,91 | good thermally conductive substrate |
| 10 | anode oxide film |
| 20,200 | thermoelectric conversion module |

PREFERRED MODE FOR CARRYING OUT THE INVENTION

Hereinafter, modes for carrying out the present invention will be explained with reference to the drawings.

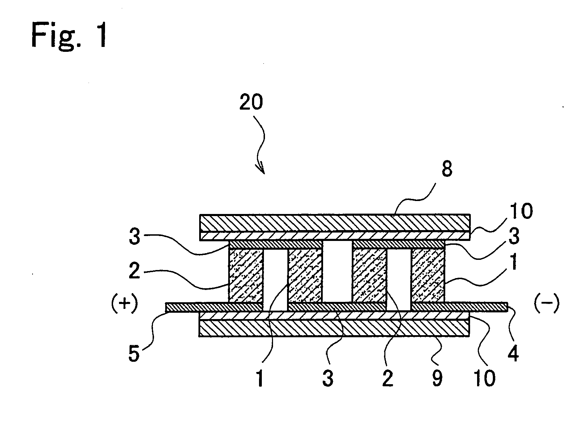

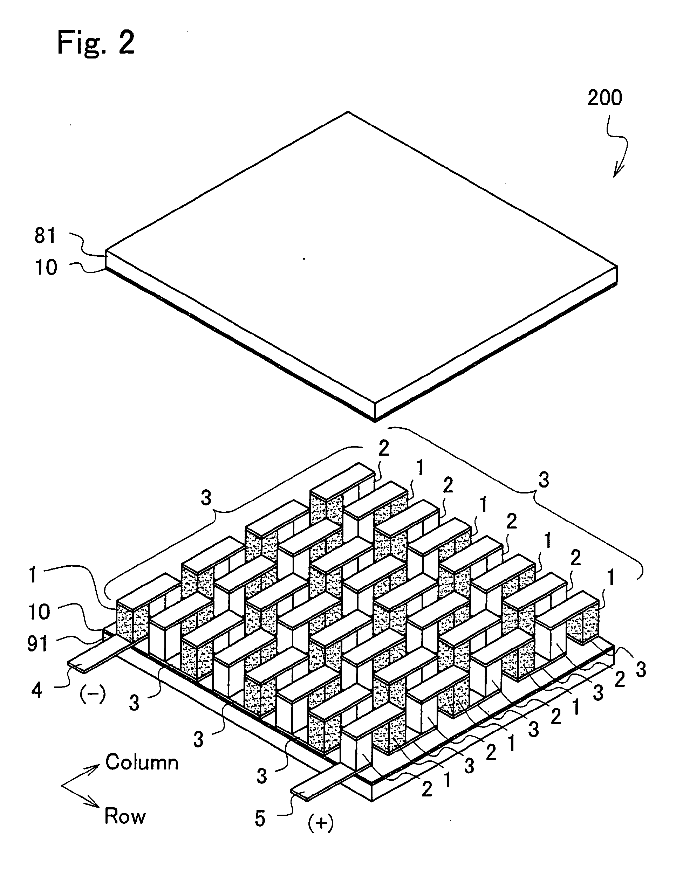

Fig. 1 shows a front view illustrating the construction of the thermoelectric conversion module according to one embodiment of the present invention. Fig. 2 shows an exploded, perspective view illustrating the thermoelectric conversion module according to another embodiment of the present invention. With respect to reference numerals assigned to the conventional components shown in Fig. 3, the same reference numerals are assigned to the corresponding components in the following description, and thus the description of the corresponding component may be omitted in some cases.
First, the construction of the thermoelectric conversion module of the present invention will be explained in contrast to the conventional thermoelectric conversion module shown in Fig. 3.
In Fig. 1, the P-type semiconductor 1 and the N-type semiconductor 2 are alternately provided in parallel. The P-type semiconductor 1 and the N-type semiconductor 2 are connected via the electrode 3 to form a π-shape. To the bottom end face of the P-type semiconductor 1 disposed on one edge side is connected an electrode 4 which is externally connected, and to the bottom end face of the N-type semiconductor 2 disposed on another edge side is connected an electrode 5 which is externally connected. The P-type semiconductors 1 and the N-type semiconductors 2 are serially connected between the electrode 4 and the electrode 5 to form π-shapes.
In Fig. 1, a good thermally conductive substrate 8 comes in contact with an electrode 3 connected to the upper end face of the P-type semiconductors 1 and the N-type semiconductors 2. A good thermally conductive substrate 9 comes in contact with the electrodes 3 to 5 connected to the bottom end faces of the P-type semiconductor 1 and the N-type semiconductor 2.
These good thermally conductive substrates 8 and 9 consist of the aluminum or aluminum alloy, and an anode oxide film 10 is provided between the good thermally conductive substrates 8, 9, and the electrodes 3 to 5. The anode oxide film 10 is formed on the good thermally conductive substrates 8 and 9 consisting of the aluminum or the aluminum alloy. The anode oxide film 10 is formed to have a film thickness of 0.1 to 0.5 $\mu$m.
In Fig. 1, a direct-current power source is connected between the electrode 4 and the electrode 5. Thus, when the electrical current flows through the thermoelectric conversion module 20 with the electrode 5 serving as the positive (+) side, and the electrode 4 serving as the negative (-) side, the good thermally conductive substrate 8 is cooled, while the good thermally conductive substrate 9 is heated.
In contrast, when a closed circuit is constructed by connecting a load between the electrode 4 and the electrode 5 in Fig. 1, and a temperature difference is imparted between the good thermally conductive substrate 8 and the good thermally conductive substrate 9 with the good thermally conductive substrate 8 serving as the low temperature side; and the good thermally conductive substrate 9 serving as the high temperature side, an electrical current flows in the closed circuit, which can be drawn as electric power.

Next, the construction of the thermoelectric conversion module according to another embodiment will be explained.

In Fig. 2, 32 P-type semiconductors 1 and 32 N-type semiconductors 2 formed into columnar shapes are alternately arranged. The 32 P-type semiconductors 1 and the 32 N-type semiconductors 2 have generally the same height, and the 32 P-type semiconductors 1 and the 32 N-type semiconductors 2 are serially connected to form π-shapes.

As shown in Fig. 2, the 32 P-type semiconductors 1 and the 32 N-type semiconductors 2 are alternately arranged along in columns, and the electrodes 3 are connected to both end faces of the multiple thermoelectric conversion element units in the direction of the columns. Additionally, each one end face of a pair of the P-type semiconductor 1 and the N-type semiconductor 2 arranged at both edges in the column direction is connected to the electrode 3.

In Fig. 2, to the bottom end face of the P-type semiconductor 1 arranged at the leading row of the leading column, is connected the electrode 4 which is externally connected, and to the bottom end face of the N-type semiconductor 2 arranged at the terminal row of the leading column, is connected the electrode 5 which is externally connected. The 32 P-type semiconductors 1 and the 32 N-type semiconductors 2 are serially connected to form π-shapes between the electrode 4 and the electrode 5.

With regard to these multiple electrodes 3 to 5, the multiple thermoelectric conversion element units are arranged in the aligned orientation such that the multiple electrodes 3 arranged on one face correspond to the heat absorbing side, and the multiple electrodes 3 to 5 arranged on another face correspond to the heat releasing side. The arranged multiple electrodes 3 to 5 are sandwiched between the good thermally conductive substrates 81 and 91 to be brought into contact thereto.

For example, a heat insulating columnar support not shown in the figure may be interposed between the pair of the opposing good thermally conductive substrates 81 and 91 to sandwich the multiple thermoelectric conversion element units. Alternatively, a nonconductive liquid packing not shown in the figure may be interposed between the pair of the opposing good thermally conductive substrates 81 and 91, and the liquid packing may adhere to the pair of the opposing good thermally conductive substrates 81 and 91 to sandwich the multiple thermoelectric conversion element units.

These good thermally conductive substrates 81 and 91 consist of the aluminum or aluminum alloy, and the anode oxide film 10 is provided between the good thermally conductive substrates 81, 91, and the electrodes 3 to 5. The anode oxide film 10 is formed on the good thermally conductive substrates 81 and 91 consisting of the aluminum or aluminum alloy. The anode oxide film 10 is formed to have a film thickness of 0.1 to 0.5 $\mu$m.

Because the thermoelectric conversion module 200 includes the multiple thermoelectric conversion element units arranged in this manner, the desired electric power can be obtained from a thermoelectric generation element module, or a desired cooling ability can be obtained from a Peltier element, by appropriately setting the number of the thermoelectric conversion element units.

Next, the operation of the thermoelectric conversion module according to the present invention will be explained.

In the thermoelectric conversion module having the construction shown in Fig. 1 to Fig. 3, the good thermally conductive substrate is expected to have low thermal resistance, along with an electrical insulating property. The thermal resistance of such a good thermally conductive substrate may be generally determined by the following general formula:

$$R \ (m^2 \cdot K/W) = t \ (m)/k \ (W/(m \cdot K)),$$

wherein R represents the thermal resistance; t represents the thickness of the good thermally conductive substrate; and k represents the coefficient of thermal conductivity.

When a typical value of "20 (W/(m · K))" is substituted for the coefficient of thermal conductivity k of the good thermally conductive substrate consisting of aluminum oxide (hereinafter, designated as $Al_2O_3$ plate); a typical value of "170 (W/(m · K))" is substituted for the coefficient of thermal conductivity k of the good thermally conductive substrate consisting of aluminum nitride (hereinafter, designated as AlN plate); and a value of "230 (W/(m · K))" is substituted for the coefficient of thermal conductivity k of the good thermally conductive substrate consisting of the aluminum or the aluminum alloy (hereinafter, designated as Al plate), the following values are derived by calculating the thermal resistance of the good thermally conductive substrate having a thickness of "1 mm" according to the above formula.

$$Al_2O_3 \ plate: \ 5.0 \times 10^{-5} \ (m^2 \cdot K/W)$$

$$\text{AlN plate: } 5.88 \times 10^{-6} \ (\text{m}^2 \cdot \text{K/W})$$

$$\text{Al plate: } 4.35 \times 10^{-6} \ (\text{m}^2 \cdot \text{K/W})$$

As described above, the Al plate exhibits the smallest value of the thermal resistance; however, it is not preferred to bring the Al plate into direct contact with the electrode connected to the both end faces of the thermoelectric conversion element units, because the Al plate has conductivity. Therefore, the anode oxide film is provided between the good thermally conductive substrate consisting of the aluminum or the aluminum alloy, and the electrode in the present invention.

Next, thermal resistance is calculated when the anode oxide film is formed on the Al plate. Provided that the anode oxide film having a film thickness of "0.5 $\mu$m" is formed on the Al plate, and that the thickness of the "Al plate + anode oxide film" is "1 mm", the value of the composite thermal resistance is as follows.

$$\text{Al plate + anode oxide film } (0.5 \ \mu\text{m}): 4.37 \times 10^{-6} \ (\text{m}^2 \cdot \text{K/W})$$

Thus, the thermal resistance value when the anode oxide film is formed on the Al plate is "$4.37 \times 10^{-6}$" which can be construed as being almost identical to the thermal resistance value of "$4.35 \times 10^{-6}$" for the Al plate alone. In addition, the anode oxide film according to the present invention is of the barrier type, the film thickness of which can be lessened to 0.5 $\mu$m, and has a sufficient electrical insulating property to withstand a voltage of approximately 400 V.

The anode oxide film formed on the Al plate may be a porous film, but the average film thickness of a porous film is usually 20 to 100 $\mu$m which is greater than that of barrier-type films. Provided that the porous film with an average film thickness of "40 $\mu$m" is formed on the Al plate, and that the thickness of the (Al plate + porous film) is 1 mm, the value of the composite thermal resistance is as follows.

$$\text{Al plate + porous film } (40 \ \mu\text{m}): 6.17 \times 10^{-6} \ (\text{m}^2 \cdot \text{K/W})$$

Thus, the thermal resistance value when the porous film is formed on the Al plate is "$6.17 \times 10^{-6}$", being greater than the thermal resistance value of the aforementioned AlN plate, i.e., "$5.88 \times 10^{-6}$". Herein, the coefficient of thermal conductivity k of the anode oxide film is assumed to be "20 (W/(m $\cdot$ K))". Therefore, in the case of the porous films, the value of the coefficient of thermal conductivity is expected to be lower than the above value. In this case, the composite thermal resistance value will be greater.

The relationship between the average film thickness ($\mu$m) of the anode oxide film and the thermal resistance value (m$^2 \cdot$ K/W) is shown in Table 1 below. In Table 1, the thermal resistance value is determined assuming that the coefficient of thermal conductivity k of the anode oxide film is "20 (W/(m $\cdot$ K))".

Table 1

|      | Lower limit | Upper limit |
|------|-------------|-------------|
| D    | 5.0         | 20          |
| R1   | 8           | 60          |
| R2   | 6           | 20          |
| Deg1 | 3           | 30          |
| Deg2 | 10          | 40          |

**Claims**

1. A thermoelectric conversion module comprising:

a thermoelectric conversion element unit constructed with a P-type semiconductor and an N-type semiconductor connected to form a $\pi$-shape, an electrode connected to each end face of the thermoelectric conversion element unit, and a good thermally conductive substrate which is in contact with the electrode, wherein the good thermally conductive substrate comprises aluminum or an aluminum alloy, and an anode oxide film is provided between the good thermally conductive substrate and the electrode.

2. The thermoelectric conversion module according to claim 1 wherein the anode oxide film is formed on the good thermally conductive substrate consisting of the aluminum or the aluminum alloy.

3. The thermoelectric conversion module according to claim 2 wherein the anode oxide film is formed to have a film thickness of 0.1 to 0.5 $\mu$m.

4. The thermoelectric conversion module according to any one of claims 1 to 3, wherein multiple thermoelectric conversion element units provided in parallel are sandwiched between the good thermally conductive substrates.

Fig. 1

# Fig. 2

Column

Row

## Fig. 3

## INTERNATIONAL SEARCH REPORT

| International application No. |
| --- |
| PCT/JP2005/009577 |

A. CLASSIFICATION OF SUBJECT MATTER
Int.Cl⁷ H01L35/32, H02N11/00

According to International Patent Classification (IPC) or to both national classification and IPC

B. FIELDS SEARCHED

Minimum documentation searched (classification system followed by classification symbols)
Int.Cl⁷ H01L35/32, H02N11/00

Documentation searched other than minimum documentation to the extent that such documents are included in the fields searched
Jitsuyo Shinan Koho       1922-1996    Jitsuyo Shinan Toroku Koho    1996-2005
Kokai Jitsuyo Shinan Koho  1971-2005    Toroku Jitsuyo Shinan Koho    1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2003-332642 A  (Komatsu Electronics Kabushiki Kaisha), 21 November, 2003 (21.11.03), Claim 3; Par. Nos. [0024] to [0025]; Fig. 2 (Family: none) | 1-4 |
| X | JP 2002-374010 A  (Kabushiki Kaisha YYL), 26 December, 2002 (26.12.02), Claims 5, 7 to 8 (Family: none) | 1-4 |
| X | JP 10-125963 A  (Chichibu Onoda Cement Corp.), 15 May, 1998 (15.05.98), Claim 1 (Family: none) | 1-4 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 15 July, 2005 (15.07.05) | 02 August, 2005 (02.08.05) |

| Name and mailing address of the ISA/ Japanese Patent Office | Authorized officer |
| --- | --- |
| Facsimile No. | Telephone No. |

Form PCT/ISA/210 (second sheet) (January 2004)

**EP 1 780 809 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001326394 A